Europäisches Patentamt

European Patent Office

Office européen des brevets

(11) Publication number: **0 075 079**
**A1**

(12) **EUROPEAN PATENT APPLICATION**

(21) Application number: **82105774.2**

(22) Date of filing: **29.06.82**

(51) Int. Cl.³: **G 01 R 31/28**

(30) Priority: **21.09.81 US 304137**

(43) Date of publication of application: **30.03.83**
**Bulletin 83/13**

(84) Designated Contracting States: **DE FR GB**

(71) Applicant: **International Business Machines Corporation, Armonk, N.Y. 10504 (US)**

(72) Inventor: **Iannucci, Robert Alan, 1055 Southern Artery, Quincy, MA 02169 (US)**

(74) Representative: **Barth, Carl Otto, Dipl.-Ing. et al, IBM Europäische Patentdienste Rabistrasse 24, D-8000 München 80 (DE)**

(54) **Circuit network checking system.**

(57) A system for checking the integrity of interconnections (21) between monolithic circuit structures (19, 23) such as circuit chips or modules. A reference voltage source (37) is provided on each circuit structure, and comparator means (33), one for each interconnection, are also provided. The comparator means compares the voltage on the interconnection with the reference voltage. If the interconnection voltage differs from the reference voltage by more than a predetermined value, an error signal is generated.

EP 0 075 079 A1

## CIRCUIT NETWORK CHECKING SYSTEM

This invention relates to circuit network checking systems, particularly for determining the integrity of circuit networks extending between monolithic circuit chips and/or modules. More particularly, the invention relates to an improved circuit network integrity checking system which determines that the voltages on a circuit network fall within a predetermined circuit operating range.

In the IBM Technical Disclosure Bulletin, Volume 22, No. 8B, January 1980, on pages 3679 and 3680, there is shown and described a circuit checking arrangement in which signals on control lines are used to set checking latches. This arrangement does not contemplate detecting departures from predetermined marginal voltage limit on the control lines. However, it has been found advantageous to know these departures from predetermined voltage limits in order to better control and determine chip/module integrity.

It is accordingly a principal object of this invention to provide circuit network checking system for interconnections between monolithic circuit chips, which system detects departures from predetermined voltage ranges on the connection.

This invention provides a novel circuit checking arrangement particularly useful in connection with integrated circuit technology. The integrity of circuits extending from one chip to another, or among modules comprising several chips is of ever increasing importance. Integrity of circuitry contained on a single chip is usually assured by quality control of manufacturing of the semiconductor circuitry per se. It accordingly becomes in-

EN 981 010

creasingly important to check the proper operations of the chip-to-chip, or module-to-module connections. In the preferred mode of the present invention, the voltage on the connection network is compared with a reference voltage. If the network voltage is not within a predetermined set of limits, an error signal is generated. With the advent of large-scale integration (LSI) it is now economically feasible to provide such a checking arrangement for each connecting line to a chip.

An embodiment of the invention is described below in connection with the appended drawings, in which:

Fig. 1    is a voltage level diagram which illustrates the relationship of possible voltage levels on a signal line.

Fig. 2    is a schematic diagram of an interconnecting circuit network between two chips and is illustrative of a preferred embodiment of the invention.

Fig. 3    is a detailed circuit diagram of one comparator circuit which can be used in the arrangement shown in Fig. 2.

Fig. 4    is a schematic diagram showing a plurality of interconnections between chips, each interconnection having a network checking circuit associated therewith.

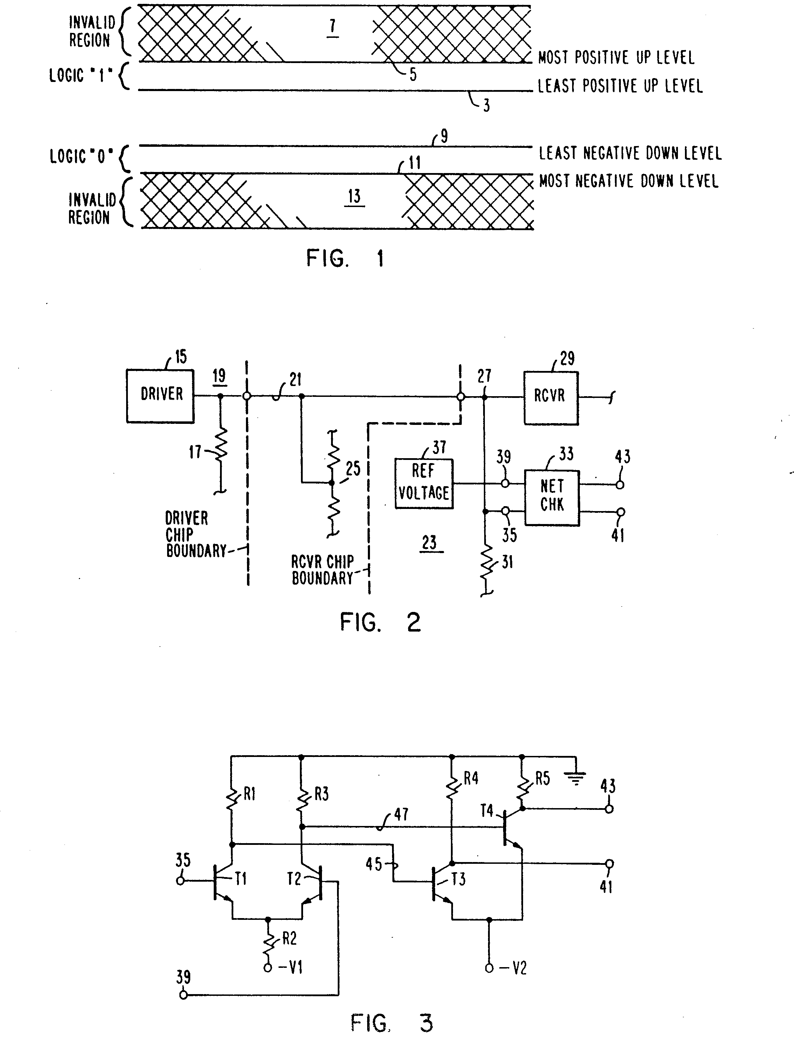

In semiconductor circuits, particular circuit families will have certain values of voltage which are considered to represent a logic value of "1" and other values of voltage which are considered to represent a logic value

EN 981 010

of "0". As shown in Fig. 1, a logic "1" is defined as a voltage between the least positive up level 3 and the most positive up level 5. Any voltage in the region higher than level 5 is considered to be in an invalid region 7. Similarly, the valid voltage range for a logic "0" is defined as lying between a least negative down level 9 and a most negative down level 11. Any voltage excursion lower or more negative than level 11 is considered to be in an invalid region 13. When a break or open circuit occurs in the circuit connections, the circuit net will float to a technology-specific voltage level, at the receiving end. Such breaks can occur in wire connections, printed circuit connections, solder connections, etc. In any case, the voltage will enter an invalid area such as regions 7 or 13 as shown in Fig. 1. The examples shown assume a ground-down logic circuit technology. The invention pertains equally well to ground-up technologies.

A circuit network of the type involved is shown in Fig. 2, in which a driver 15 has associated therewith a pull-down resistor 17, both being located on a first chip 19. The driver drives an interconnecting line 21 which extends to a second chip 23. A terminator network 25 may be attached to the line 21. Line 21 is connected to an input terminal 27 of a receiver 29 located on chip 23. Also connected to terminal 27 is a receiver pull-down resistor 31.

A network checking circuit 33 is connected to terminal 27 via a terminal 35. A reference voltage source 37 is also connected to the checking circuit 33 via a terminal 39. Error signal outputs from the checking circuit are supplied, when they occur, to terminals 41 and 43, as a

- 4 -  0075079

result of the voltage at terminal 7 entering one of the invalid regions of Fig. 1. The details of an appropriate checking circuit 33 are shown in Fig. 3. Input terminal 35 is connected to the base of a first transistor T1, the emitter of which is connected to the emitter of a second transistor T2 and via a resistor R2 to a negative voltage source V1. The base of transistor T2 is connected to the reference voltage source 37 via terminal 39. The collectors of transistors T1 and T2 are connected to ground via resistors R1 and R3 respectively, and are also connected via lines 45 and 47 to the bases of transistors T3 and T4. The emitters of T3 and T4 are connected together and to a negative voltage source V2, and the collectors of T3 and T4 are connected to ground via resistors R4 and R5 respectively. Output terminals 41 and 43 are also connected to the collectors of transistors T3 and T4, respectively.

In operation, if the voltage at terminal 27 increases positively to a value in the invalid region, it will exceed the reference voltage level turning on transistor T1 which will in turn turn off transistor T3, causing an error output signal to appear at terminal 41. The arrangement as shown is for a "float up" check. For a "float down" check, the lines 45 and 47 should be interchanged at one end thereof.

For optimum operation, resistor R2 should be as large as possible and resistor R1 should be as small as possible, to provide a high input impedance and a small linear region for the comparator. The reference voltage source 37 can be any temperature-stabilized source. Source 37 and checking circuit 33 are located, of course, on the same chips as receiver 29.

EN 981 010

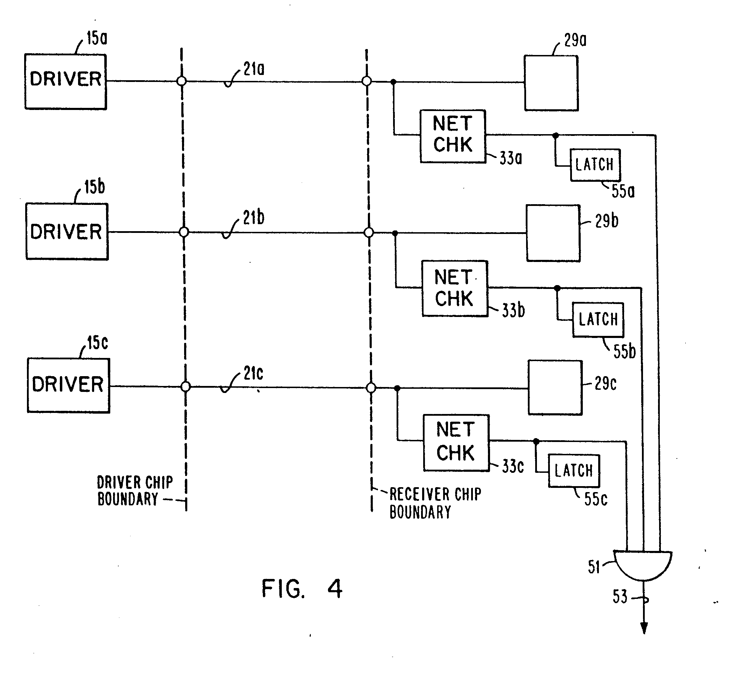

Fig. 4 shows a plurality of interconnections 21a, 21b and 21c between two circuit chips. Driver 15a, 15b and 15c supply signals to their associated lines, which signals are received by the associated receivers 29a, 29b and 29c. The integrity of the connections is checked by the network check circuits 33a, 33b and 33c. Fig. 4 also illustrates how the error output signals from the check circuits can be combined, as by an OR circuit 51, to provide a single error output line 53 which will have an output thereon if any interconnection to the chip fails. Also, the error output signals may be used to set associated latches such as latches 55a, 55b and 55c, to preserve an indication of an improper voltage excursion.

This system provides improved detection of defects or errors on any type of electrical signal line (control, data, or other) improved fault isolation, a savings in circuitry as compared with parity checking, residue checking, etc., and a savings in the number of input and output connections on the associated chips or modules.

EN 981 010

- 6 -                                    0075079

CLAIMS

1. A system for checking the integrity of circuit
   networks between a plurality of monolithic circuit
   structures (19, 23) in which a plurality of inter-
   connections (21) are provided, comprising a
   plurality of interconnection terminals (27) on
   said circuit structures, a reference voltage
   source (37) on at least one of said structures (23),
   and means for comparing (33) the voltage on each of
   said terminals with said reference voltage and
   providing an error output signal when the voltage
   on any said interconnection terminal differs from
   said reference voltage by more than a predetermined
   value.

2. The checking system of claim 1, having a reference
   voltage source (37) on each of said circuit
   structures (19, 23), a plurality of comparators
   (33) on said circuit structures, one comparator
   for each of said interconnections, each of said
   comparators having a reference voltage input
   terminal (39) connected to said reference voltage
   source, and having a signal voltage input terminal
   (35) connected to the associated interconnection
   terminal (27), and at least one error signal output terminal (41) for each of said comparators,
   said comparators providing an error output signal
   on said error output terminal when the signal voltage at the associated interconnection terminal
   varies from said reference voltage by more than a
   predetermined margin voltage value.

EN 981 010

3. The checking system of claim 2, wherein said comparators (33) have their signal voltage input terminals (35) connected to an associated interconnection terminal (27) for input signals only.

4. The checking system of claim 2, wherein said comparators (33) are responsive to a signal voltage of a given polarity only.

5. The checking system of claim 2, wherein each said comparator (33) has a true and a complementary error output signal.

6. The checking system of claim 2, further comprising logic circuit means (51) on each of said circuit structures (19, 23) for combining the outputs of said comparators (33) to provide a common error output signal.

INVALID REGION

LOGIC "1"

MOST POSITIVE UP LEVEL

LEAST POSITIVE UP LEVEL

LOGIC "0"

LEAST NEGATIVE DOWN LEVEL

MOST NEGATIVE DOWN LEVEL

INVALID REGION

FIG. 1

DRIVER

RCVR

REF VOLTAGE

NET CHK

DRIVER CHIP BOUNDARY

RCVR CHIP BOUNDARY

FIG. 2

FIG. 3

IBM - EN 981 010

FIG. 4

| | DOCUMENTS CONSIDERED TO BE RELEVANT | | EP 82105774.2 |
|---|---|---|---|

| Category | Citation of document with indication, where appropriate, of relevant passages | Relevant to claim | CLASSIFICATION OF THE APPLICATION (Int. Cl. 3) |
|---|---|---|---|
| A | DD - A - 94 858 (HOFMANN)<br>* Column 4, lines 15-19; column 1, lines 26-30 *<br>-- | | G 01 R 31/28 |
| A | IEEE JOURNAL OF SOLID STATE CIRCUITS, vol. sc-15, no. 3, June 1980<br>KÖNEMANN, MUCHA & ZWIEHOFF "Built-In Test for Complex Digital Integrated Circuits",<br>pages 315-318<br>* Introduction *<br>---- | | |

| | TECHNICAL FIELDS SEARCHED (Int. Cl. 3) |
|---|---|
| | G 01 R 31/00<br>H 01 L 21/00 |

| X | The present search report has been drawn up for all claims | | |
|---|---|---|---|
| | Place of search<br>VIENNA | Date of completion of the search<br>10-11-1982 | Examiner<br>KUNZE |